# EUROPEAN PATENT APPLICATION

(11) **EP 2 000 566 A2**
(43) Date of publication of application: **10.12.2008**
(21) Application number: 08010282.5
(22) Date of filing: 05.06.2008
(51) Int. Cl.: C30B 25/18, C30B 29/22, H01L 21/205, H01L 21/203

(54) **Interlayer of orientational substrate and orientational substrate for forming epitaxial film**

(30) Priority: 05.06.2007 JP 2007149339
(71) Applicant: Chubu Electric Power Co., Inc., Nagoya Aichi 461-8680 (JP); Tanaka Kikinzoku Kogyo K.K., Chiyoda-ku Tokyo 100-6422 (JP)
(72) Inventor: Doi, Toshiya, Kagoshima-shi Kagoshima 890-8580 (JP); Kashima, Naoji, Nagoya Aichi 459-8522 (JP); Nagaya, Shigeo, Nagoya Aichi 459-8522 (JP); Shima, Kunihiro, Tomioka-shi Gunma 370-2452 (JP)
(74) Representative: Dey, Michael

(57) **Abstract**

[Problem to be Solved]

Provided is an interlayer of a textured substrate for forming an epitaxial film that permit the formation of an epitaxial film having a high texture.

[Means for Solution]

The present invention provides an interlayer of a textured substrate for forming an epitaxial film that is provided between a base material and an epitaxial film formed on at least one surface of the base material, in which the interlayer has a single layer structure or a multilayer structure of not less than two layers and a layer in contact with the substrate is formed from an indium tin oxide. This interlayer can have a multilayer structure, and can be provided on the ITO layer, with at least one layer formed from nickel, nickel oxide, zirconium oxide, a rare earth oxide, magnesium oxide, strontium titanate (STO), strontium titanate-barium (SBTO), titanium nitride, silver, palladium, gold, iridium, ruthenium, rhodium, and platinum.

## Description

### TECHNICAL FIELD

The present invention relates to an interlayer used in a thin-film-formed surface of a textured substrate for forming an epitaxial film, and a textured substrate provided with this interlayer. More particularly, the invention relates to an interlayer provided for forming an epitaxial film having a good texture and a textured substrate.

### BACKGROUND ART

In a textured substrate used to form an epitaxial film with a specific texture, the surface is formed so as to provide a crystal structure having orientation, whereby the texture of an epitaxial film formed thereon is ensured and it is ensured that the epitaxial film exhibits its characteristics. Investigations are made into application of such textured substrates on which an epitaxial film is formed to various functional materials, such as oxide superconductors and semiconductor devices.

In a textured substrate for forming an epitaxial film, an interlayer present between a substrate surface and an epitaxial film is often formed. This is because if an epitaxial film is formed directly on a substrate having no interlayer, there is a fear that defects, such as partial crystal strains, may occur due to a difference in physical properties, such as lattice constant, between component materials and a base material. For this reason, there has hitherto been known a method that involves forming an interlayer made of, for example, YSZ (yttria-stabilized zirconia), CeO₂ (cerium oxide) and the like on a base material surface and forming an epitaxial film thereon in order to ensure the matching of the lattice constant (refer to National Publication of International Patent Application No. 2006-513553).

However, even with a textured substrate in which an interlayer is provided as described in Cited Reference 1, the texture of a formed epitaxial film may sometimes not become sufficiently uniform. Also, an epitaxial firm that is inadequate in terms of characteristics even when texture is ensured, may sometimes be formed.

Therefore, the present invention has an object to provide an interlayer of a textured substrate for forming an epitaxial film that permits the formation of a high-quality epitaxial film having a good texture.

### DISCLOSURE OF THE INVENTION

To solve the above problem, the present inventors devoted themselves to studies of factors responsible for a decrease in the quality of an epitaxial film when an interlayer is used, and as a result, they considered that there is a problem in the growth of grooves at the grain boundaries of a base material surface during the formation of an interlayer. This is because if grooves grow at the grain boundaries of a base material surface, fluctuations are likely to occur in the texture of the interlayer on the base material, resulting in changing the characteristics of the epitaxial film.

And the present inventors considered that the growth of grooves during the formation of an interlayer is attributed to a fact that the forming temperature of an interlayer is high. For example, the forming temperature of an interlayer made of YSZ is not less than 750°C and the forming temperature of an interlayer made of CeO₂ is not less than 800°C. Thus, in general, a high temperature atmosphere not less than 700°C is required. It is thought that if the formation of an interlayer is performed with the substrate surface subjected to such a high temperature atmosphere, grooves of the grain boundaries of the substrate surface will grow and result in fluctuations in the crystal orientation in the vicinity of the grain boundaries. Therefore, the present inventors studied interlayers capable of being formed at low temperatures at which the groove growth of the base material surface does not occur, and finally made the present invention.

That is, the present invention provides an interlayer of a textured substrate for forming an epitaxial film that is provided between a base material and an epitaxial film formed on at least one surface of the base material, in which the interlayer has a single layer structure or a multilayer structure of not less than two layers and a layer in contact with the substrate is made of an indium tin oxide.

The interlayer according to the present invention is such that a layer in contact with the base material surface is formed from an indium tin oxide (which hereinafter is sometimes called an ITO). When an ITO is used, an interlayer can be formed at not more than 700°C and if necessary, at not more than 400°C. Therefore, the growth of grooves at the grain boundaries of the base material surface can be prevented, and it becomes possible to form an epitaxial film having a high texture on the base material surface.

In addition to the fact that an ITO enables a film to be formed at a low temperature, an ITO has a feature that a film can be formed in a reducing atmosphere. This provides the advantage that an interlayer can be formed without oxidizing a base material and that it is possible to prevent the delamination of a film due to the formation of an oxide on the base material surface. Furthermore, an ITO is an electrically conductive substance whose application to a transparent electrode is known, and is also applicable to a device of which electrical conductivity is required between an epitaxial film and a substrate.

Incidentally, it is preferred that the ITO in the present invention has a tin content of not more than 20%. When electrical conductivity is required of an ITO layer, it is preferred that the tin content be not less than 10%. However, for the prevention of the groove growth on the base material surface, which is a problem to be tackled in the present invention, there is no problem even if the tin content is less than 10% (0%).

The interlayer according to the present invention may be either of a single layer structure or of a multilayer structure, and any interlayer is allowed so long as the bottom layer (a layer in contact with the base material surface) is made of an ITO. That is, because the interlayer is used to ensure the matching of the lattice constant between the base material and the epitaxial film, in a case where a difference between the lattice constant of an aimed epitaxial film and the lattice constant of an interlayer ITO is small, the interlayer may be an ITO single layer.

On the other hand, in a case where the lattice constant of an epitaxial film to be formed differs greatly from the lattice constant of the ITO, it is preferred that the interlayer according to the present invention should have a multilayer structure. In this case, it is preferred that the layer formed on the ITO layer be provided with at least one layer made of nickel, nickel oxide, zirconium oxide, a rare earth oxide, magnesium oxide, strontium titanate (STO), strontium titanate-barium (SBTO), titanium nitride, silver, palladium, gold, iridium, ruthenium, rhodium, and platinum. These materials are those which are capable of epitaxial growth on the ITO and suitable for the matching of the lattice constant. The number and kinds of the metal and compound layers that constitute the interlayer are appropriately selected according to the kind of the epitaxial film formed thereon.

It is preferred that a surface roughness Ra of a surface (a junction face with the epitaxial film) of the above-described interlayer of a textured substrate be not more than 10 nm. If the surface roughness Ra is large, the thickness distribution of the epitaxial film formed on the interlayer becomes nonuniform and there is a fear that this might affect the characteristics of the epitaxial film. It is preferred that the lower limit to the surface roughness Ra be as small as possible. However, in consideration of working limits and efficiency, it is preferred that the lower limit to the surface roughness Ra be not less than 0.1 nm.

It is preferred that the film thickness of the ITO film in the interlayer according to the present invention be 10 nm to 1000 nm. If this film thickness is less than 10 nm, it is difficult to form a continuous ITO film and the base material might be locally exposed, whereas on the other hand cracks may occur if the film thickness exceeds 1000 nm. And it is preferred that the film thickness of the interlayer in the case of a multilayer structure be 20 nm to 500 nm.

Various kinds of thin film forming methods can be adopted as the forming method of the interlayer according to the present invention; they are, for example, the PLD (pulse laser deposition) method, the CVD (chemical vapor deposition) method, the sputtering method, the vacuum evaporation method, the ion plating method, the ion beam deposition method, the spin coating method, the MBE (molecular beam epitaxy) method, and the plating method. The PLD method is a preferred method. This is because with this film forming method, the chemical composition of a target and the chemical composition of a formed thin film are closely similar to each other, and because a thin film having an aimed chemical composition can be easily formed by adjusting the target.

It is preferred that the base material for the above-described textured substrate be made of any one of nickel, silver and copper or alloys of these metals or austenitic stainless steels. Because the interlayer is formed under the influence of the texture of the base material, in order to ensure the texture of an epitaxial film formed thereon, it is preferred that the texture of the base material be also good. The above-described materials are relatively easily improved in terms of the texture by adjusting the working conditions and heat treatment conditions of the materials. Although the base material may be of a single layer of the above-described materials, in order to impart strength and flexibility to the material after the formation of an epitaxial film, the base material may also be a substrate having a multilayer structure in which other materials that work as reinforcing materials are clad to the above-described materials. It is preferred that the cladding material be made of any one of stainless steel, nickel alloys (Hastelloy alloys, Inconel alloys, Incoloy alloys, Monel alloys and the like). Furthermore, the thickness and shape of the substrate are not especially limited, and shapes suitable for the use, such as plate-like shape, foil-like and tape-like substrates, can be applied.

As described above, the interlayer of a textured substrate for forming an epitaxial film according to the present invention can form a high-quality epitaxial film having a high texture and expected characteristics. The epitaxial film formed by using the present invention is not especially limited so long as it is formed by epitaxial growth. The epitaxial film formed by using the present invention can be advantageously used in an oxide superconductor, for example, and a superconductor layer having a good texture can be formed.

### BRIEF DESCRIPTION OF THE DRAWINGS

FIG. 1 is a pole figure of an ITO plane of a textured substrate related to First Embodiment;
FIG. 2 is a (103) pole figure of a superconductor film (YBCO) according to Second Embodiment;
FIG. 3 is a (103) pole figure of a superconductor film (YBCO) according to Third Embodiment;
FIG. 4 is a SEM image of a superconductor film surface according to Third Embodiment;
FIG. 5 is a (103) pole figure of superconductor film (YBCO) according to Comparative Example 2 or 3; and
FIG. 6 is a SEM image of superconductor film surface according to Comparative Example 2 or 3.

### BEST MODE FOR CARRYING OUT THE INVENTION

Best mode for carrying out the invention will be described below.

### First Embodiment:

A copper tape plate having a {100}<001 > cube texture (Δφ ≤ 6°), which had beforehand been subjected to orientation treatment, was prepared as a base material. Before the preparation of an interlayer, the surface of the copper plate was subjected to ion-beam etching for 20 minutes to remove matter adsorbed on the surface. Next, an interlayer consisted of an ITO film was formed on one surface of this base material. The formation of the ITO film was performed by the PLD method. By using an ITO (tin oxide content: 10 wt%) as a target, an ITO film having a film thickness of 350 nm was formed at a substrate temperature of 650°C, at a gas pressure of 3.8 × 10⁻² Pa, and with a laser frequency of 2.5 Hz. A textured substrate provided with an interlayer of a single ITO layer was fabricated by the above-described steps.

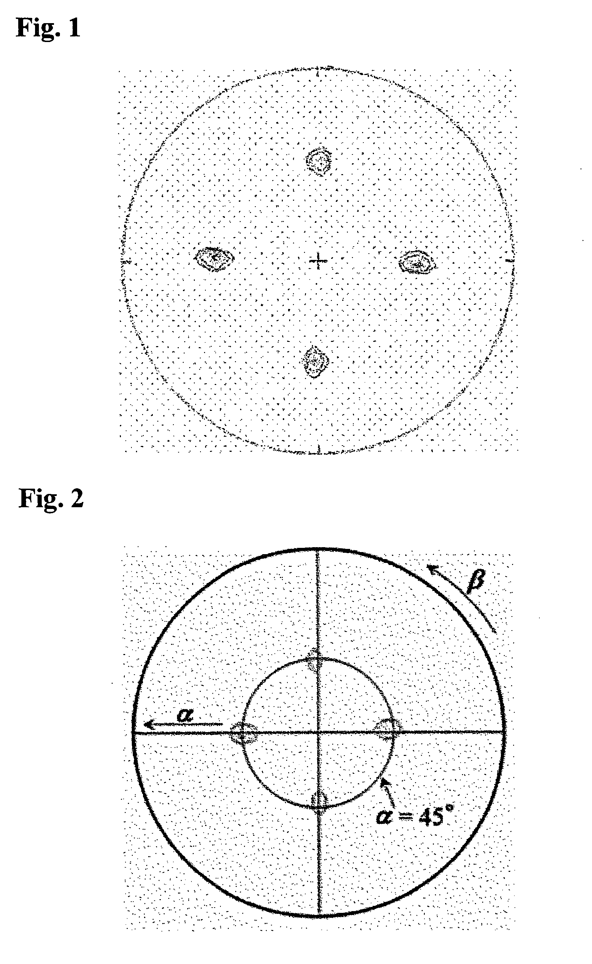

The surface of the fabricated textured substrate provided with an ITO layer was subjected to an X-ray pole figure analysis (XPFA). FIG. 1 is an ITO {111} pole figure obtained in this analysis. As is apparent from FIG. 1, this ITO interlayer has a clear biaxial oriented structure.

### Second Embodiment:

In this embodiment, a textured substrate provided with an interlayer of a multilayer structure with an ITO film as the bottom layer was fabricated by using the copper tape fabricated in the first embodiment as a base material, and a superconductor (YBCO) was formed thereon as an epitaxial film.

First, an ITO film was formed on a tape-like copper base material as used in the first embodiment under the same conditions as in the first embodiment. And upon the ITO film, a multilayer film of YSZ and the like was formed as follows. After that, a superconductor film was formed. The formation of the interlayer and the superconductor film was performed by the PLD method.

**[Table 1]**

| Composition | | Material | Lattice constant | Film thickness | Manufacturing conditions | | |
|---|---|---|---|---|---|---|---|
| | | | | | Target | Substrate temperature | Gas pressure (Pa) |
| Base material | | Cu | 3.62 Å | - | - | - | - |
| Interlayer | First layer | ITO | 10.12 Å | 350 nm | ITO | 650°C | 3.8 × 10⁻² (Ar) |
| | Second layer | YSZ | 5.15 Å | 100 nm | YSZ | 750°C | 3.8 × 10⁻² (Ar) |
| | Third layer | CeO₂ | 5.41 Å | 100 nm | CeO₂ | 800°C | 3.8 × 10⁻² (Ar) |
| | Fourth layer | STO | 3.91 Å | 100 nm | STO | 850°C | 3.8 × 10⁻² (Ar) |
| | Fifth layer | MgO | 4.21 Å | 500 nm | MgO | 800°C | 3.8 × 10⁻² (Ar) |
| | Sixth layer | SBTO | 3.97Å | 200 nm | SBTO | 750°C | 3.8 × 10⁻² (Ar) |
| Superconductive film | | YBCO | 3.88 Å | 500 nm | YBCO | 780°C | 35 (O₂) |

A superconductor film (YBCO) was formed on the interlayer of the above-described structure, and an X-ray pole figure analysis of the surface of the superconductor film was performed. FIG. 2 shows a (103) pole figure of the YBCO surface. As is apparent from the figure, it could be ascertained that the YBCO film shows a good biaxial oriented structure also on the interlayer formed in this embodiment.

### Comparative Example 1:

To make a comparison with the above-described first and second embodiments, an interlayer made of CeO₂ was formed in a copper base material. The same copper base material as used in the second embodiment was prepared, and a CeO₂ film (film thickness: 200 nm) was formed by the PLD method (substrate temperature: 750□, gas pressure (oxygen): 5 Pa).

In this comparative example, the substrate after the formation of the CeO₂ film was observed. It was found that the whole substrate had been blackened and that wrinkling and delamination had occurred in the CeO₂ film. When the base material surface of a delamination face was observed under magnification, roughening of the structure was seen. It might be thought that this is because groove growth and oxidation occurred at the grain boundaries of the base material (copper) surface due to a high-temperature, oxidizing atmosphere during the formation of the CeO₂ film.

### Third Embodiment:

In this embodiment, a textured substrate in which an interlayer of a multilayer structure with ITO as the bottom layer is formed on a nickel base material, was fabricated, and a superconductor (YBCO) was formed thereon as an epitaxial film.

An ITO film was formed under the same conditions as used in the first and second embodiments on a tape-like nickel tape material having a {100}<001 > cube texture (Δφ ≤ 7°), which had been subjected to orientation treatment. And upon the ITO film, a superconductor film was formed by forming a cerium oxide film and the like as shown in Table 2. The formation of the interlayer and the superconductor film was performed by the PLD method.

**[Table 2]**

| Composition | | Material | Lattice constant | Film thickness | Manufacturing conditions | | |
|---|---|---|---|---|---|---|---|
| | | | | | Target | Substrate temperature | Gas Pressure (Pa) |
| Base material | | Ni | 3.52 Å | - | - | - | - |
| Interlayer | First | ITO | 10.12 Å | 350 nm | ITO | 650°C | 3.8 × 10⁻² (Ar) |
| | Second layer | YSZ | 5.15 Å | 100 nm | YSZ | 750°C | 3.8 × 10⁻² (Ar) |
| | Third layer | CeO₂ | 5.41 Å | 100 nm | CeO₂ | 800°C | 3.8 × 10⁻² (Ar) |
| Superconductive film | | YBCO | 3.88 Å | 500 nm | YBCO | 780°C | 35 (O₂) |

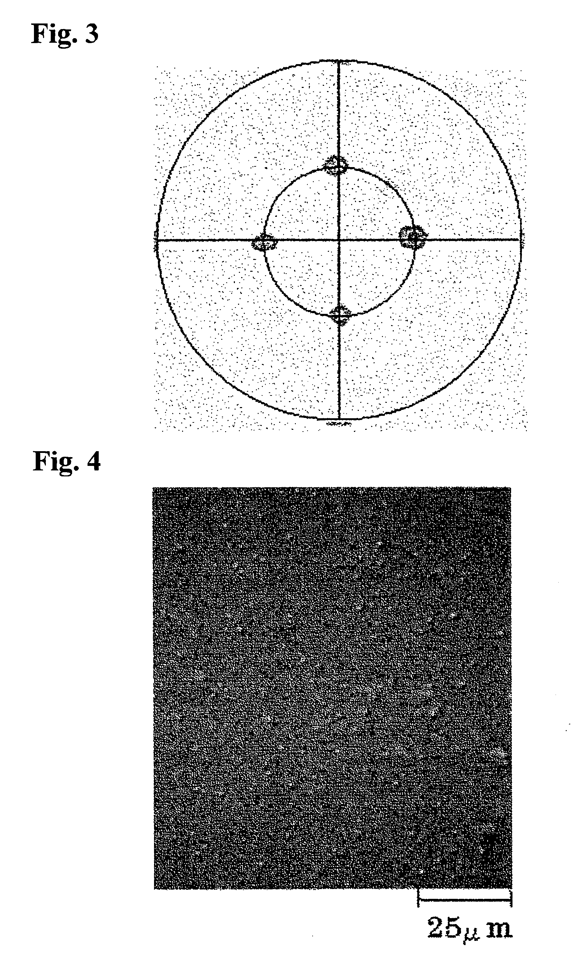

An X-ray pole figure analysis of the superconductor film (YBCO) formed on a textured substrate having an interlayer of this three-layer structure was performed. FIG. 3 shows a YBCO (103) pole figure. As is apparent from the figure, it was ascertained that the YBCO film formed on the interlayer formed in this embodiment has a good biaxially oriented structure.

FIG. 4 is a SEM image of the morphology of a superconductor film surface. As is apparent from FIG. 4, the surface has a relatively smooth morphology without growth of groove. The critical current density (Jc) of the fabricated superconductor tape was measured, and high values of not less than 3 MA/cm² were obtained.

### Comparative Examples 2 and 3:

To make a comparison with the above-described third embodiment, an interlayer of a multilayer structure having CeO₂ as the bottom layer was formed on a nickel base material and a superconductor film was formed. The same nickel base material as used in the second embodiment was prepared, and a CeO₂ film, a YSZ film and a superconductor film were formed by the PLD method (Table 3). The film formation conditions of each layer in the comparative examples were basically the same as in the third embodiment, with the exception that only the film forming temperature of the CeO₂ film, which is the bottom layer, was changed.

**[Table 3]**

| Composition | | Material | Lattice constant | Film thickness | Substrate temperature |
|---|---|---|---|---|---|
| Base material | | Ni | 3.52 Å | - | - |
| Interlayer | First layer | CeO₂ | 5.41 Å | 200 nm | 750°C (Comparative Example 2) 650°C (Comparative Example 3) |
| | Second layer | YSZ | 5.15 Å | 100 nm | 750°C |
| | Third layer | CeO₂ | 5.41 Å | 100 nm | 800°C |
| Superconductive film | | YBCO | 3.88 Å | 500 nm | 780°C |

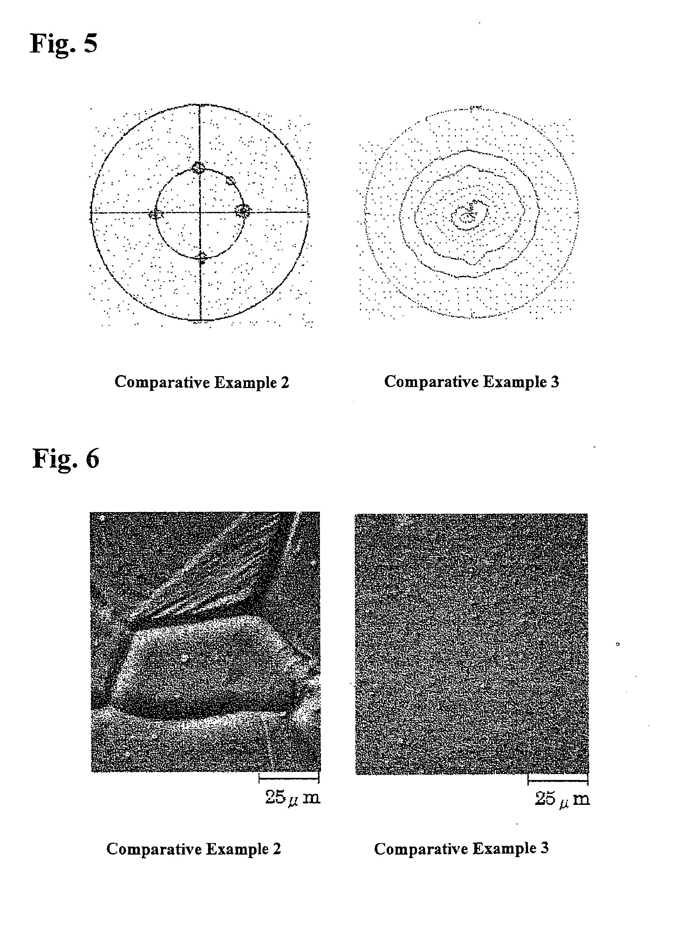

In the same manner as with the third embodiment, an X-ray pole figure analysis, a SEM observation and the measurement of the Jc value were carried out for the superconductor film surfaces of Comparative Examples 2 and 3. For these results, FIG. 5 shows a pole figure, and FIG. 6 shows a SEM image of the surface morphology.

When the film forming temperature of the CeO₂ film in Comparative Example 2, which is the bottom layer, was 750°C, the orientation of the superconductor film was good. However, for the surface morphology, the growth of grooves was clearly observed. It is considered attributed to that grooves grew at the grain boundaries of the nickel base material due to the adoption of a high temperature as the film forming temperature of the CeO₂ film, which is the bottom layer. When Jc of the superconductor film was measured, Jc showed a low value of 0.11 MA/cm². Therefore, it was ascertained that the textured substrate of Comparative Example 2 was unable to suppress growth of groove and a decrease in performance although the texture of the epitaxial film can be ensured.

On the other hand, in Comparative Example 3, orientation was not seen in the superconductor film formed on the CeO₂ film although the growth of grooves did not occur because the CeO₂ film was formed at a low temperature (650°C). And also the Jc value was 0.12 MA/cm², which is a low value. Therefore, it was ascertained that the textured substrate related to Comparative Example 3 cannot display its essential function of ensuring the orientation of the epitaxial film thereon.

From a comparison between the third embodiment and Comparative Examples 2 and 3, it is apparent that in order to prevent growth of groove while imparting a sufficient texture to an epitaxial film, it is necessary to form an interlayer having a good texture even at low temperature on the base material surface. And an ITO meets the conditions, and as in the present invention, it is possible to form a good epitaxial film by forming an ITO interlayer on the base material surface.

## Claims

1. An interlayer of a textured substrate for forming an epitaxial film that is provided between a base material and an epitaxial film formed on at least one surface of the base material, wherein the interlayer has a single layer structure or a multilayer structure of not less than two layers, and a layer in contact with the substrate is made of an indium tin oxide.

2. The interlayer of a textured substrate for forming an epitaxial film according to claim 1, wherein the interlayer has a multilayer structure and is provided, on the indium tin oxide layer, with at least one layer made of nickel, nickel oxide, zirconium oxide, a rare earth oxide, magnesium oxide, strontium titanate (STO), strontium titanate-barium (SBTO), titanium nitride, silver, palladium, gold, iridium, ruthenium, rhodium, and platinum.

3. The interlayer of a textured substrate for forming an epitaxial film according to claim 1 or 2, wherein a surface roughness Ra at a junction face with the epitaxial film is not more than 10 nm.

4. The interlayer of a textured substrate for forming an epitaxial film according to any one of claims 1 to 3, wherein the film thickness of the indium tin oxide film is 10 to 1000 nm.

5. A textured substrate for forming an epitaxial film having the interlayer according to any one of claims 1 to 4.
